# EUROPEAN PATENT SPECIFICATION

(11) **EP 2 806 242 B1**
(45) Date of publication and mention of the grant of the patent: **11.12.2019**
(21) Application number: 12865722.8
(22) Date of filing: 19.01.2012
(51) Int. Cl.: F28D 15/02, H01L 23/427, B23P 15/00, F28F 3/02, B21D 53/02, F28D 15/04

(54) **MANUFACTURING METHOD OF TEMPERATURE EQUALIZATION DEVICE WITHOUT LIQUID INJECTION TUBE AND TEMPERATURE EQUALIZATION DEVICE MANUFACTURED BY THE METHOD**
HERSTELLUNGSVERFAHREN FÜR EINE TEMPERATURAUSGLEICHSVORRICHTUNG OHNE FLÜSSIGKEITSINJEKTIONSROHR UND IN DIESEM VERFAHREN HERGESTELLTE TEMPERATURAUSGLEICHSVORRICHTUNG
PROCÉDÉ DE FABRICATION DE DISPOSITIF D'ÉGALISATION DE TEMPÉRATURE SANS TUBE D'INJECTION DE LIQUIDE ET DISPOSITIF D'ÉGALISATION DE TEMPÉRATURE FABRIQUÉ PAR LE PROCÉDÉ

(43) Date of publication of application: 26.11.2014
(73) Proprietor: Acmecools Tech. Ltd., Tortola (VG)
(72) Inventor: CHIN, Chite, Taichung City 403 Taiwan (TW)
(74) Representative: Straus, Alexander
(86) International application number: PCT/CN2012/070611
(87) International publication number: WO 2013/107026

(56) References cited:
- CN-A- 1 832 156
- CN-A- 1 832 156
- CN-A- 101 394 726
- CN-A- 101 451 791
- CN-A- 101 520 286
- CN-A- 101 520 286
- CN-A- 101 605 445
- CN-A- 101 605 445
- CN-Y- 201 378 002
- DE-U1-202007 007 568

## Description

### BACKGROUND OF THE INVENTION

### 1. Technical Field

The present invention relates to heat-dissipating technology, and more particularly, to a method of manufacturing a heat-dissipating device without injection tube.

### 2. Description of Related Art

Conventional heat-dissipating devices, such as flat heat pipes, loop heat pipes, and vapor chambers, perform heat transfer by a liquid phase change of a working medium.

A manufacturing process of a conventional vapor chamber entails welding the periphery thereof, drilling, pipe-welding, performing vacuum filling, sealing pipe mouth, and spot welding. Alternatively, the manufacturing process entails reserving a filling hole during the step of pressing upper and lower covers of the vapor chamber to thereby dispense with the aforesaid drilling step. However, an injection tube 0.5∼3 cm long usually remains outside of the vapor chamber thus manufactured. Furthermore, the vapor chamber thus manufactured is usually flawed with inefficient temperature uniformity or heat transfer because the control over the manufacturing process is hardly easy. Furthermore, an exposed injection tube is a good location where stress is concentrated; as a result, the exposed injection tube is susceptible to damage, unreliable, and likely to be hit and severed because it is exposed.

In view of this, the inventor of this application filed a patent application (US 2009/0288815 A1) later, to put forth a injection tube-free heat transfer device that solves the problems facing the conventional heat transfer device. The inventor of this application developed a technique, which is innovative and novel when compared with what is disclosed in the aforesaid patent, and filed this patent application based on the technique. DE202007007568 discloses a heat pipe, which has the shape of a flat plate, and a sink, which use this heat pipe. The heatpipe has the function of absorbing heat anywhere on its surface and distributing it over its entire surface. This is achieved with the aid of a liquid transport medium. The heat transfer is much faster than in solid copper, and the temperature is the same over the entire surface. CN1832156 discloses a radiating device, which can be a uniform heat cavity combined with any heating components. The device includes a closed cavity and a capillary structure formed on the inside wall of said cavity, in which, said capillary structure includes multiple grooves formed on the inside wall of the cavity and porous powder sintered under high temperature on the inside wall , thus the radiating device has good capillary force of sintered capillary structure and penetrability of groove structure to speed up the radiation backflow of the working liquid and increase the radiation efficiency of the device.

### SUMMARY OF THE INVENTION

It is an objective of the present invention to provide a method of manufacturing a heat-dissipating device without an injection tube which has novelty over the prior art, feature high reliability, and has high heat dissipation performance.

In order to achieve the above and other objectives, the present invention provides a method of manufacturing a heat-dissipating device without injection tube, according to the wording of claim 1.

In order to achieve the above and other objectives, the present invention provides a heat-dissipating device without injection tube, comprising: an upper casing and a lower casing, wherein a receiving space is defined therebetween, and the receiving space has therein a capillary, a brace, and a liquid working medium; the capillary comprising an upper portion and a lower portion; the brace positioned between the upper portion and the lower portion to space apart the upper portion and the lower portion; the liquid working medium being of predetermined quantity, wherein the capillary and the brace are sintered to thereby be coupled to the upper casing and the lower casing; and a crevice formed by welding a seam between the upper and lower casings and sealed hermetically by high-energy welding.

Accordingly, the present invention provides a manufacturing method, which has novelty over the prior art, feature high reliability, and have high heat dissipation performance, wherein a liquid working medium injecting location (that is, fissure) is a smooth hermetically sealed surface.

### BRIEF DESCRIPTION OF THE SEVERAL VIEWS OF THE DRAWINGS

Structures and features of the present invention are hereunder illustrated with preferred embodiments in conjunction with the accompanying drawings, in which:
FIG. 1 is a schematic view of an upper casing and a lower casing according to the first preferred embodiment of the present invention;
FIG. 2 is a schematic view of the upper casing and the lower casing which are put together according to the first preferred embodiment of the present invention;
FIG. 3 is a cross-sectional view taken along line 3-3 of FIG. 2;
FIG. 4 is an exploded view of the first preferred embodiment of the present invention;
FIG. 5 is a schematic view of the partial structure of the first preferred embodiment of the present invention, illustrating a brace;
FIG. 6 is a schematic view of a finished product according to the first preferred embodiment of the present invention;
FIG. 7 is a schematic view of the second preferred embodiment of the present invention, showing that the upper and lower casings have upper and lower wicks, respectively;
FIG. 8 is an exploded view of the third preferred embodiment of the present invention; and
FIG. 9 is a cross-sectional schematic view of the third preferred embodiment of the present invention.

### DETAILED DESCRIPTION OF THE EMBODIMENTS OF THE INVENTION

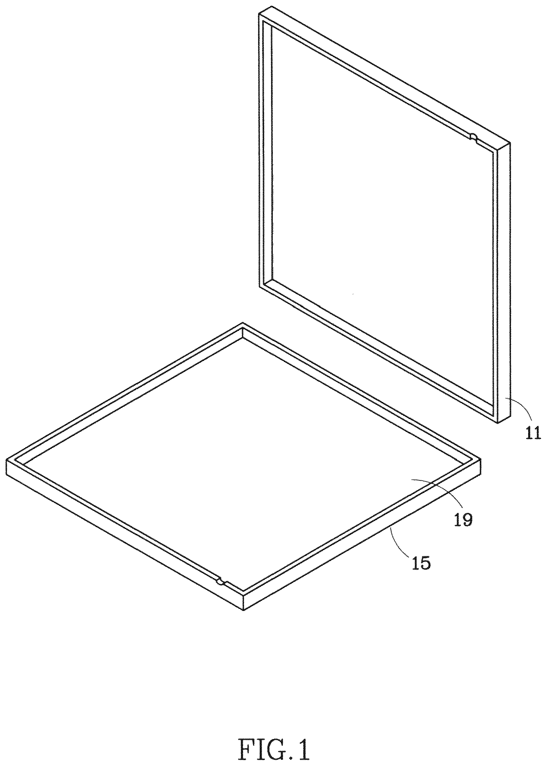

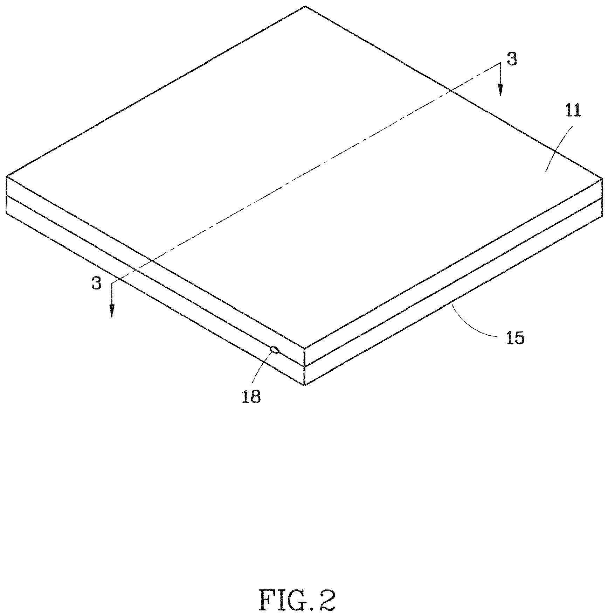

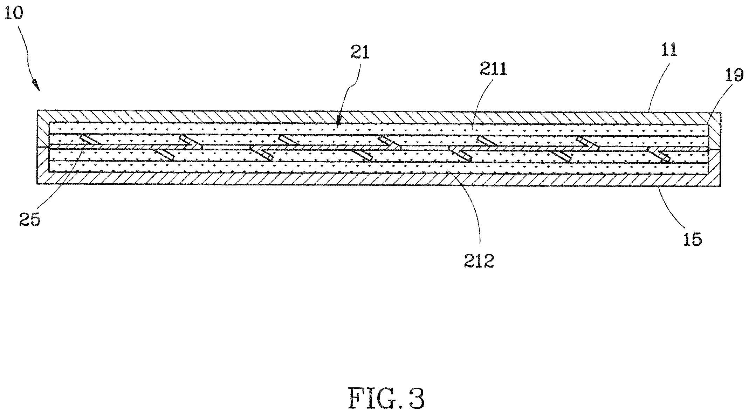

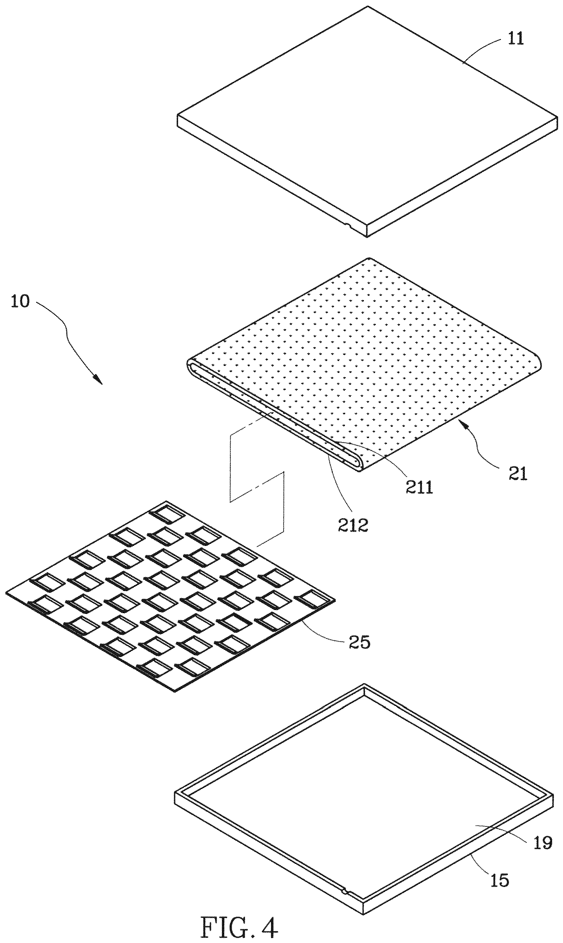

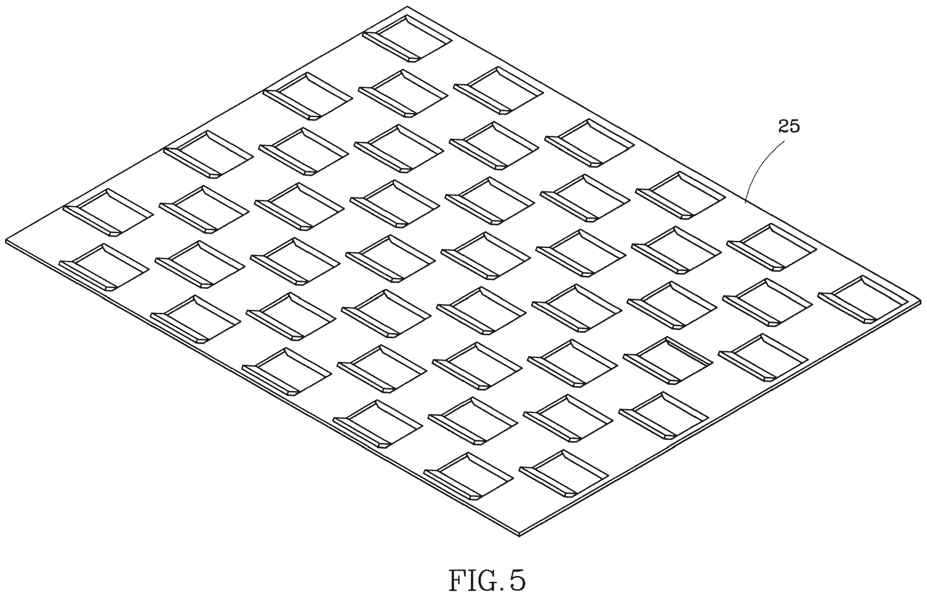

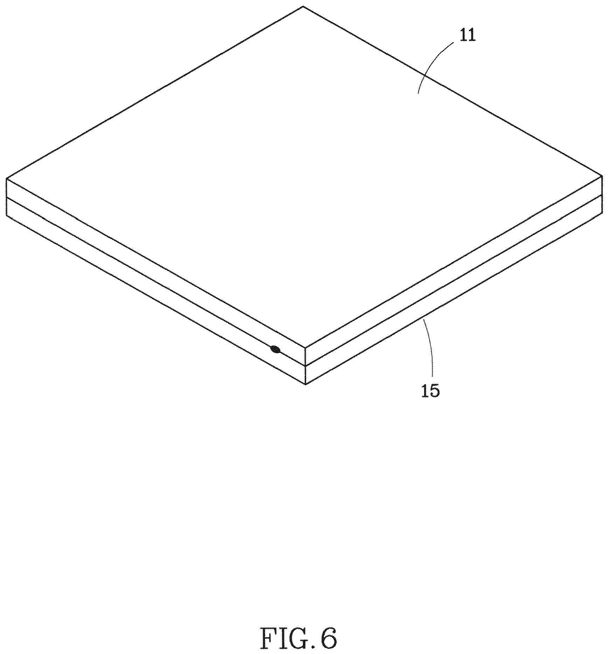

Referring to FIG. 1 through FIG. 6, in the first preferred embodiment of the present invention, a method of manufacturing a heat-dissipating device without injection tube essentially comprises the steps of:
a) providing an upper casing 11 and a lower casing 15, such that a receiving space 19 is defined between the upper casing 11 and the lower casing 15 (see FIG. 1);
b) positioning a capillary 21 and a brace 25 in the receiving space 19, welding the upper casing 11 and the lower casing 15 together in a manner to seal the seam therebetween hermetically and reserving a crevice 18, wherein the capillary 21 comprises an upper portion 211 and a lower portion 212, the upper portion 211 being in contact with the bottom surface of the upper casing 11, the lower portion 212 being in contact with the top surface of the lower casing 15, the brace 25 being disposed between the upper portion 211 and the lower portion 212 to support and space apart the upper portion 211 and the lower portion 212 (see FIG. 2 through FIG. 4); in this embodiment, the capillary 21 is an annular metallic mesh that forms the upper portion 211 and the lower portion 212 instantly and spontaneously when positioned in the receiving space 19; due to the annularity of the capillary 21, the upper portion 211 and the lower portion 212 are connected on two sides thereof; the brace 25 is a net frame or a plurality of supporting posts; this embodiment is exemplified by a net frame with a structure shown in FIG. 5 and composed of a net board and a plurality of supporting plates formed thereon and there beneath;
c) sintering the combination of the upper casing 11 and the lower casing 15 welded together in step b);
d) injecting a liquid working medium (which is not shown in the diagrams not only because it is liquid and thus difficult to depict, but also because it is a conventional element) from the crevice 18 into the receiving space 19, wherein the liquid working medium thus injected is of predetermined quantity; in this embodiment, a fine needle (which is disclosed in the prior art and thus is not shown in the diagrams) is inserted into the crevice 18, and the liquid working medium is injected into the receiving space 19 with the fine needle; and
e) clamping, with a clamp (which is known in the prior art and thus is not shown in the diagram), a combination of the upper casing 11 and the lower casing 15 into which the liquid working medium has been injected in step d) in a vacuum environment, putting the combination of the upper casing 11 and the lower casing 15 in a vacuum environment, and welding the crevice 18 quickly to seal the crevice 18 hermetically, so as to manufacture a finish product of an heat-dissipating device 10, as shown in FIG. 6. In this embodiment, the crevice 18 is welded by high-energy welding to serve an illustrative purpose, wherein the high-energy welding is one of electronic-beam welding, high-frequency argon arc welding, and laser welding.

By following the aforesaid steps, it is feasible to manufacture the heat-dissipating device 10 comprising the upper casing 11, the lower casing 15, the capillary 21, the brace 25, the liquid working medium, and the crevice 18. The receiving space 19 is defined between the upper casing 11 and the lower casing 15. The capillary 21, the brace 25, and the liquid working medium are disposed in the receiving space 19. The capillary 21 has an upper portion 211 and a lower portion 212. The upper portion 211 is in contact with the bottom surface of the upper casing 11. The lower portion 212 is in contact with the top surface of the lower casing 15. The brace 25 is positioned between the upper portion 211 and the lower portion 212 and adapted to space apart the upper portion 211 and the lower portion 212. The liquid working medium is of predetermined quantity.

The capillary 21 and the brace 25 are sintered to thereby be coupled to the upper casing 11 and the lower casing 15.

The crevice 18 is formed by welding a seam between the upper and lower casings 11, 15 and sealed hermetically by high-energy welding.

As indicated above, the seam between the upper and lower casings 11,15 is sealed hermetically. The upper portion 211 and the lower portion 212 of the capillary 21 in the receiving space 19 defined between the upper and lower casings 11,15 are in contact with inner surfaces of the upper and lower casings 11,15, respectively. The brace 25 spaces apart the upper portion 211 and the lower portion 212. Hence, given the space defined by the brace 25 and the capillarity of the capillary 21, the liquid working medium is provided with a satisfactory gaseous and liquid loop path while a phase change is taking place to thereby achieve a quick temperature uniformity. It has a liquid working medium injecting location (that is, the location of the crevice 18) which is a smooth hermetically sealed surface, and thus does not have a conventional exposed injection tube, and therefore is not confronted with issues pertaining to reliability of an exposed injection tube.

Hence, the manufacturing method in the first embodiment, which have novelty over the prior art, not only features absence of an exposed injection tube and thus reduction in required volume, but also feature satisfactory reliability and heat dissipation performance.

In the first embodiment, the capillary is a metallic mesh which is illustrative of the present invention rather than restrictive of its constituent ingredients or structure. Alternatively, the capillary is a sintered copper powder. A sintered copper powder is a conventional element, and the way it is installed is disclosed in the prior art; hence, the sintered copper powder is not described herein in detail for the sake of brevity.

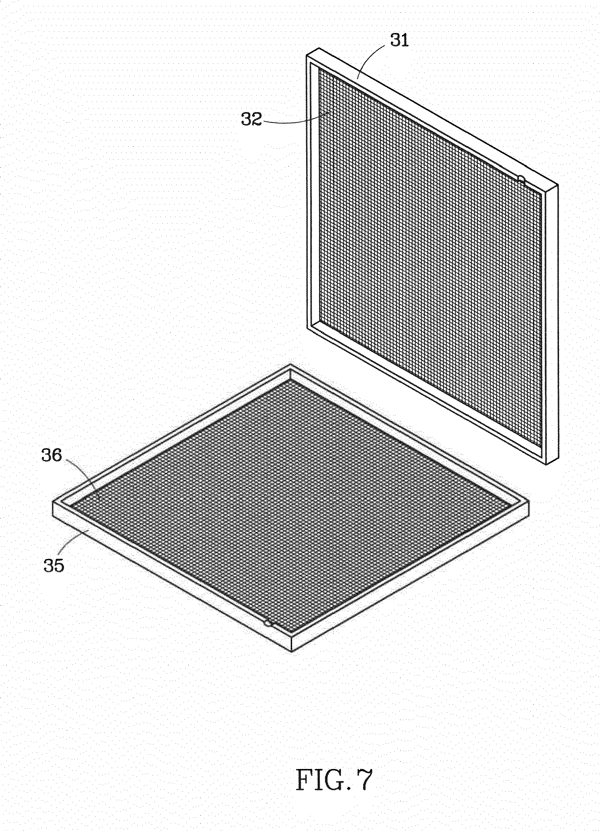

Referring to FIG. 7, the differences between a method of manufacturing a heat-dissipating device without injection tube in the second preferred embodiment of the present invention and its counterpart in the first embodiment of the present invention are described as follows:
In step a), an upper wick 32 is disposed on the bottom surface of the upper casing 31, and a lower wick 36 is disposed on the top surface of the lower casing 35. In the second embodiment, the upper wick 32 and the lower wick 36 are a plurality of grooves.

Hence, the upper wick 32 and the lower wick 36 increase the channel of a liquid, such that the liquid working medium in the second embodiment has a better loop effect than the liquid working medium in the first embodiment.

In the second embodiment, the upper wick and the lower wick are a plurality of grooves which are illustrative of the present invention rather than restrictive of their constituent ingredients or structure. Alternatively, the upper wick and the lower wick are a sintered copper powder or a metallic mesh. A sintered copper powder and a metallic mesh are conventional elements, and the way they are installed is disclosed in the prior art; hence, they are not described herein in detail for the sake of brevity.

The other structures, operation, and anticipated advantages of the second embodiment are the same as that of the first embodiment and thus are not described in detail herein for the sake of brevity.

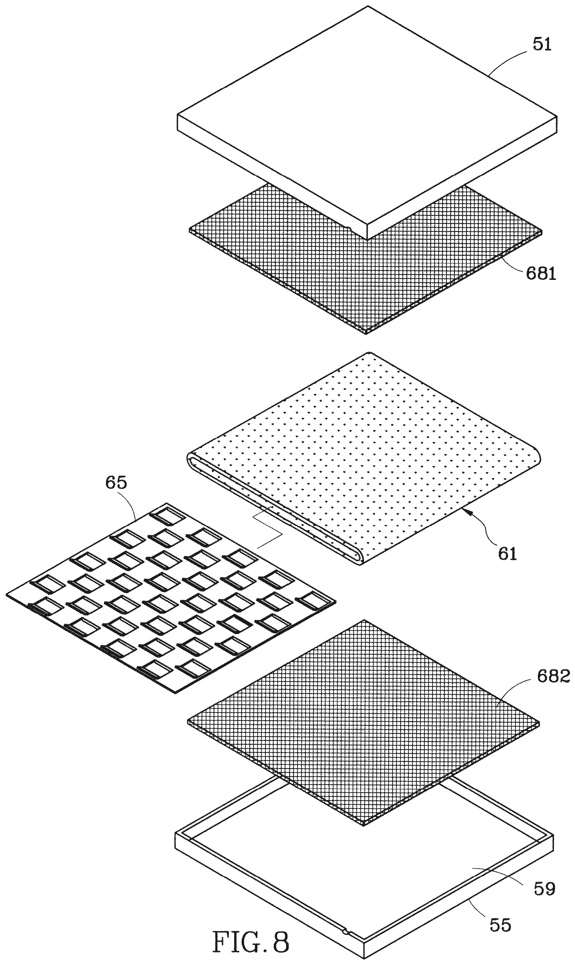

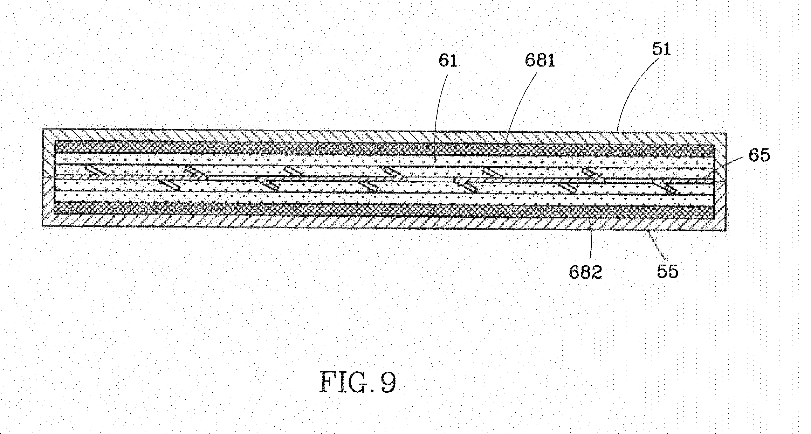

Referring to FIG. 8 through FIG. 9, the differences between a method of manufacturing a heat-dissipating device without injection tube in the third preferred embodiment of the present invention and its counterpart in the first embodiment of the present invention are described as follows:
Step b) further involves positioning an upper auxiliary capillary 681 between the capillary 61 and the upper casing 51 and positioning a lower auxiliary capillary 682 between the capillary 61 and the lower casing 55 while positioning a capillary 61 and a brace 65 in the receiving space 59. The upper auxiliary capillary 681 and the lower auxiliary capillary 682 are a metallic mesh or a sintered copper powder. In the third embodiment, the upper auxiliary capillary 681 and the lower auxiliary capillary 682 are a metallic mesh to serve an illustrative purpose.

Unlike the first embodiment, the third embodiment features an upper auxiliary capillary 681 and a lower auxiliary capillary 682 and thereby features a loop-like path of a liquid working medium, thus further enhancing the quick temperature uniformity.

Furthermore, in the third embodiment, a layer of auxiliary capillary is disposed between the capillary and the upper and lower casings to increase the loop-like path. Understandably, two or more layers of auxiliary capillary are equivalent to a simple change to the third embodiment and thus should be covered by the claims of the present invention.

The other structures, operation, and anticipated advantages of the third embodiment are the same as that of the first embodiment and thus are not described in detail herein for the sake of brevity.

## Claims

1. A method of manufacturing a heat-dissipating device, said heat-dissipating device not including an injection tube, the method comprises the steps of:
a) providing an upper casing (11)(31)(51) and a lower casing (15)(35)(55), wherein a receiving space (19) is defined between the upper casing (11)(31)(51) and the lower casing (15)(35)(55);
b) positioning a capillary (21)(61) and a brace (25)(65) in the receiving space (19), welding the upper casing (11)(31)(51) and the lower casing (15)(35)(55) in a manner to seal a seam therebetween hermetically, and reserving a crevice (18), wherein the capillary (21)(61) comprises an upper portion (211) and a lower portion (212), and the brace (25)(65) is positioned between the upper portion (211) and the lower portion (212) to support and space apart the upper portion (211) and the lower portion (212);
c) sintering a combination of the upper casing (11)(31)(51) and the lower casing (15)(35)(55) welded together in step b);
d) injecting a liquid working medium from the crevice (18) into the receiving space (19), wherein the liquid working medium thus injected is of predetermined quantity; and
e) putting a combination of the upper casing (11)(31)(51) and the lower casing (15)(35)(55) into which the liquid working medium has been injected in step d) in a vacuum environment and welding the crevice (18) to seal the crevice (18) hermetically.

2. The method of claim 1, wherein an upper wick (32) is disposed on a bottom surface of the upper casing (31), and a lower wick (36) is disposed on a top surface of the lower casing (35).

3. The method of claim 2, **characterized in that** the upper wick (32) and the lower wick (36) are one of a plurality of grooves, a sintered copper powder, and a metallic mesh.

4. The method of claim 1,
**characterized in that** in step d), a fine needle is inserted into the crevice (18) and the liquid working medium is injected into the receiving space (19) with the fine needle; or
**characterized in that** in step e), the upper casing (11) and the lower casing (15) are clamped together with a clamp before step e) is performed; or
**characterized in that** in step b), the capillary (21)(61) is one of a metallic mesh and a sintered copper powder; or
**characterized in that** in step b), the brace (25)(65) is one of a net frame and a plurality of supporting posts; or
**characterized in that** the upper portion (211) is in contact with a bottom surface of the upper casing (11), and the lower portion (212) is in contact with a top surface of the lower casing (15).

5. The method of claim 1, **characterized in that** in step e), the crevice (18) is hermetically sealed by high-energy welding, said high-energy welding being one of electronic-beam welding, high-frequency argon arc welding, and laser welding.

6. The method of claim 1, **characterized in that** step b) further involves positioning an upper auxiliary capillary (681) between the capillary (61) and the upper casing (51) and positioning a lower auxiliary capillary (682) between the capillary (61) and the lower casing (55) while positioning a capillary (61) and a brace (65) in the receiving space (19).

7. The method of claim 6, **characterized in that** the upper auxiliary capillary (681) and the lower auxiliary capillary (682) are one of a metallic mesh and a sintered copper powder.

## Patentansprüche

1. Verfahren zur Herstellung einer Wärme-abführenden Einrichtung, worin die Wärmeabführende Einrichtung kein Injektionsrohr aufweist, wobei das Verfahren die Schritte umfasst:
a) Bereitstellen eines oberen Gehäuses (11)(31)(51) und eines unteren Gehäuses (15)(35)(55), worin zwischen dem oberen Gehäuse (11)(31)(51) und dem unteren Gehäuse (15)(35)(55) ein Aufnahmeraum (19) definiert ist;
b) Positionieren einer Kapillare (21)(61) und einer Verstrebung (25)(65) in dem Aufnahmeraum (19), Verschweißen des oberen Gehäuses (11)(31)(51) und des unteren Gehäuses (15)(35)(55) derart, dass eine hermetische Dichtung dazwischen erzeugt wird, und Vorsehen eines Spalts (18), worin die Kapillare (21)(61) einen oberen Bereich (211) und einen unteren Bereich (212) umfasst, und worin die Verstrebung (25)(65) zwischen dem oberen Bereich (211) und dem unteren Bereich (212) angeordnet ist, um den oberen Bereich (211) und den unteren Bereich (212) zu beabstanden und zu halten;
c) Sintern einer Kombination des oberen Gehäuses (11)(31)(51) und des unteren Gehäuses (15)(35)(55), die in Schritt b) zusammen verschweißt wurden;
d) Injizieren eines flüssigen Arbeitsmedium über den Spalt (18) in den Aufnahmeraum (19), worin das flüssige Arbeitsmedium in einer bestimmten Menge injiziert wird; und
e) Überführen der Kombination des oberen Gehäuses (11)(31)(51) und des unteren Gehäuses (15)(35)(55), in das das flüssige Arbeitsmedium in Schritt d) injiziert wurde, in eine Unterdruck-Umgebung und Verschweißen des Spalts (18), um den Spalt (18) hermetisch abzudichten.

2. Verfahren nach Anspruch 1, wobei ein oberer Docht (32) auf einer Bodenfläche des oberen Gehäuses (31) vorgesehen ist, und ein unterer Docht (36) auf einer oberen Oberfläche des unteren Gehäuses (35) vorgesehen ist.

3. Verfahren nach Anspruch 2, **dadurch gekennzeichnet, dass** der obere Docht (32) und der untere Docht (36) einer ist von mehreren Vertiefungen, einem gesinterten Kupferpulver, und einem Netz aus Metall.

4. Verfahren nach Anspruch 1,
**dadurch gekennzeichnet, dass** in Schritt d) eine feine Nadel in den Spalt (18) inseriert wird und das flüssige Arbeitsmedium in den Aufnahmeraum (19) mit der feinen Nadel injiziert wird; oder
**dadurch gekennzeichnet, dass** vor Durchführung von Schritt e) das obere Gehäuse (11) und das untere Gehäuse (15) in Schritt e) mit einer Klemme zusammengeklemmt sind; oder
**dadurch gekennzeichnet, dass** in Schritt b) die Kapillare (21)(61) eine ist von einem Netz aus Metall und einem gesinterten Kupferpulver; oder
**dadurch gekennzeichnet, dass** in Schritt b) die Verstrebung (25)(65) eines ist von einem Netzrahmen und mehreren Trägerstiften; oder
**dadurch gekennzeichnet, dass** der obere Bereich (211) mit einer Bodenfläche des oberen Gehäuses (11) in Kontakt steht, und dass der untere Bereich (212) mit einer oberen Oberfläche des unteren Gehäuses (15) in Kontakt steht.

5. Verfahren nach Anspruch 1, **dadurch gekennzeichnet, dass** in Schritt e), der Spalt (18) durch Hochenergieschweissen hermetisch abgedichtet ist, worin das Hochenergieschweissen eines ist von Elektronenstrahl-Schweissen, Hochfrequenz-Argon-Lichtbogenschweissen, und Laser-Schweissen.

6. Verfahren nach Anspruch 1, **dadurch gekennzeichnet, dass** Schritt b) weiter beinhaltet, Positionieren einer oberen Hilfs-Kapillare (681) zwischen der Kapillare (61) und dem oberen Gehäuse (51) und Positionieren einer unteren Hilfs-Kapillare (682) zwischen der Kapillare (61) und dem unteren Gehäuse (55) während des Positionierens einer Kapillare (61) und einer Verstrebung (65) in dem Aufnahmeraum (19).

7. Verfahren nach Anspruch 6, **dadurch gekennzeichnet, dass** die obere Hilfs-Kapillare (681) und die untere Hilfs-Kapillare (682) eines ist von einem Netz aus Metall und einem gesinterten Kupferpulver.

## Revendications

1. Procédé de fabrication d'un dispositif de dissipation de chaleur, ledit dispositif de dissipation de chaleur ne comprenant pas de tube d'injection, le procédé comprenant les étapes :
a) utilisation d'un boîtier supérieur (11)(31)(51) et d'un boîtier inférieur (15)(35)(55), un espace de réception (19) étant défini entre le boîtier supérieur (11)(31)(51) et le boîtier inférieur (15)(35)(55) ;
b) positionnement d'un capillaire (21)(61) et d'une entretoise (25)(65) dans l'espace de réception (19), soudage du boîtier supérieur (11)(31)(51) et du boîtier inférieur (15)(35)(35) de manière à fermer hermétiquement un joint entre eux et réserver une fente (18), le capillaire (21)(61) comprenant une partie supérieure (211) et une partie inférieure (212) et l'entretoise (25)(65) étant positionnée entre la partie supérieure (211) et la partie inférieure (212) pour supporter et écarter la partie supérieure (211) et la partie inférieure (212) ;
c) frittage d'une combinaison du boîtier supérieur (11)(31)(51) et du boîtier inférieur (15)(35)(55) soudés ensemble à l'étape b) ;
d) injection d'un milieu de travail liquide à partir de la fente (18) dans l'espace de réception (19), le milieu de travail liquide ainsi injecté étant de quantité prédéterminée ; et
e) placement d'une combinaison du boîtier supérieur (11)(31)(51) et du boîtier inférieur (15) (35) (55) dans laquelle le milieu de travail liquide a été injecté à l'étape d) dans un environnement sous vide et soudage de la fente (18) pour fermer hermétiquement la fente (18).

2. Procédé selon la revendication 1, un réseau capillaire supérieur (32) étant disposé sur une surface inférieure du boîtier supérieur (31) et un réseau capillaire inférieur (36) étant disposé sur une surface supérieure du boîtier inférieur (35).

3. Procédé selon la revendication 2, **caractérisé en ce que** le réseau capillaire supérieur (32) et le réseau capillaire inférieur (36) sont l'un(e) parmi une pluralité de rainures, une poudre de cuivre frittée et un treillis métallique.

4. Procédé selon la revendication 1,
**caractérisé en ce qu'**à l'étape d), une aiguille fine est insérée dans la fente (18) et le milieu de travail liquide est injecté dans l'espace de réception (19) à l'aide de l'aiguille fine ; ou
**caractérisé en ce qu'**à l'étape e), le boîtier supérieur (11) et le boîtier inférieur (15) sont serrés ensemble à l'aide d'une pince avant l'étape e) ; ou
**caractérisé en ce qu'**à l'étape b), le capillaire (21)(61) est l'un(e) parmi un treillis métallique et une poudre de cuivre frittée ; ou
**caractérisé en ce qu'**à l'étape b), l'entretoise (25)(65) est l'un(e) parmi un cadre de filet et une pluralité de montants de support ; ou
**caractérisé en ce que** la partie supérieure (211) est en contact avec une surface inférieure du boîtier supérieur (11) et la partie inférieure (212) est en contact avec une surface supérieure du boîtier inférieur (15).

5. Procédé selon la revendication 1, **caractérisé en ce qu'**à l'étape e), la fente (18) est hermétiquement fermée par soudage à haute énergie, ledit soudage à haute énergie étant l'un parmi le soudage par faisceau électronique, le soudage à l'arc sous argon à haute fréquence et le soudage au laser.

6. Procédé selon la revendication 1, **caractérisé en ce que** l'étape b) comprend en outre le positionnement d'un capillaire auxiliaire supérieur (681) entre le capillaire (61) et le boîtier supérieur (51) et le positionnement d'un capillaire auxiliaire inférieur (682) entre le capillaire (61) et le boîtier inférieur (55) tout en positionnant un capillaire (61) et une entretoise (65) dans l'espace de réception (19).

7. Procédé selon la revendication 6, **caractérisé en ce que** le capillaire auxiliaire supérieur (681) et le capillaire auxiliaire inférieur (682) sont l'un parmi un treillis métallique et une poudre de cuivre frittée.
